# EUROPÄISCHE PATENTSCHRIFT

(11) **EP 2 532 034 B1**
(45) Veröffentlichungstag und Bekanntmachung des Hinweises auf die Patenterteilung: **09.06.2021**
(21) Anmeldenummer: 11714529.2
(22) Anmeldetag: 11.04.2011
(51) Int. Cl.: H01L 33/56

(54) **OPTOELEKTRONISCHES BAUELEMENT UND VERFAHREN ZUM HERSTELLEN EINES OPTOELEKTRONISCHEN BAUELEMENTS**
OPTOELECTRONIC COMPONENT AND METHOD FOR PRODUCING AN OPTOELECTRONIC COMPONENT
COMPOSANT OPTOÉLECTRONIQUE ET PROCÉDÉ DE FABRICATION D'UN COMPOSANT OPTOÉLECTRONIQUE

(30) Priorität: 30.04.2010 DE 102010028407
(43) Veröffentlichungstag der Anmeldung: 12.12.2012
(73) Patentinhaber: OSRAM Opto Semiconductors GmbH, 93055 Regensburg (DE)
(72) Erfinder: BRUNNER, Herbert, 93161 Sinzing (DE); GALLMEIER, Hans-Christoph, 93049 Regensburg (DE); JEREBIC, Simon, 93105 Tegernheim (DE); PREUß, Stephan, 32832 Augustdorf (DE); SCHÖLL, Hansjörg, 93077 Bad Abbach (DE)
(74) Vertreter: OSRAM GmbH - GC IP
(86) Internationale Anmeldenummer: PCT/EP2011/055621
(87) Internationale Veröffentlichungsnummer: WO 2011/134777

(56) Entgegenhaltungen:
- WO-A1-2009/069671
- WO-A1-2010/035206
- DE-A1-102004 053 116
- JP-A- 8 078 450
- JP-A- 2002 050 800
- JP-A- 2004 165 308
- JP-A- 2008 047 569
- JP-A- 2009 182 307

## Beschreibung

Die vorliegende Erfindung betrifft ein optoelektronisches Bauelement und ein Verfahren zum Herstellen eines optoelektronischen Bauelements.

Bei einem optoelektronischen Bauelement wird emittierte Strahlung je nach der gewünschten Anwendung ausgekoppelt. Dabei kann es relevant sein, ob von dem optoelektronischen Bauelement Streulicht ausgestrahlt wird, oder ob die Strahlung in eine Richtung ausgerichtet sein soll. In vielen Anwendungen ist es wichtig, dass die Strahlung möglichst fokussiert in eine Richtung abgestrahlt wird. Dies ist beispielsweise bei Strahlern wichtig, wie einem Autoscheinwerfer oder einem Blitzlicht. Auch bei einer Einkopplung der emittierten Strahlung in einen Lichtwellenleiter (LWL) ist eine genaue Fokussierung der Strahlung erwünscht, um Verluste durch Streuung oder Absorption zu vermeiden.

Aus der Druckschrift WO 2009/069671 A1 ist ein optoelektronisches Bauelement mit einem optoelektronischen Halbleiterchip auf einem Chipträger bekannt. Auf dem Halbleiterchip ist ein Strahlungskonversionselement angeordnet. Seitlich sind der Halleiterchip und das Strahlungskonversionselement von einem reflektierenden Verguss umgeben. Ferner offenbart die Druckschrift ein Verfahren zur Herstellung eines solchen Bauelements.

Die Druckschrift JP 2009/182307 A beschreibt eine lichtemittierende Vorrichtung. Lichtemittierende Elemente der Vorrichtung sind von einem Dichtungselement und einem Harz umgeben.

Der vorliegenden Erfindung liegt das Problem zugrunde, ein optoelektronisches Bauelement bzw. ein Verfahren zum Herstellen eines optoelektronischen Bauelements bereitzustellen, bei dem ein gut abgegrenzter Lichtkegel aus einer Auskopplungsfläche des optoelektronischen Bauelements abgestrahlt werden kann, so dass eine Abstrahlung in eine bevorzugte Hauptrichtung erfolgt.

Dieses Problem wird durch ein optoelektronisches Bauelement gemäß dem Patentanspruch 1 sowie durch ein Verfahren zum Herstellen eines optoelektronischen Bauelements gemäß dem Patentanspruch 13 gelöst.

Weiterbildungen und vorteilhafte Ausgestaltungen des optoelektronischen Bauelements sind in den abhängigen Patentansprüchen angegeben.

### BEISPIELHAFTE AUSFÜHRUNGSFORMEN

Verschiedene Ausführungsformen des optoelektronischen Bauelements weisen einen optoelektronischen Halbleiterchip auf, der eine Kontaktseite und eine der Kontaktseite gegenüberliegende Strahlungsauskopplungsseite aufweist. Das optoelektronische Bauelement weist einen Chipträger auf, auf den der Halbleiterchip über seine Kontaktseite aufgebracht ist. Auf der Strahlungsauskopplungsseite des Halbleiterchips ist ein Strahlungskonversionselement aufgebracht. Auf dem Chipträger ist zudem eine Vergussmasse aufgebracht, die den Halbleiterchip und das Strahlungskonversionselement seitlich umschließt. Die Vergussmasse ist eine reflektierende Vergussmasse. Sie schließt im Wesentlichen bündig an eine Oberkante des Strahlungskonversionselements an, so dass eine Oberseite des Strahlungskonversionselements frei von der Vergussmasse ist.

Sowohl der Halbleiterchip als auch das Strahlungskonversionselement sind seitlich vollständig von der reflektierenden Vergussmasse umgeben. Damit kann Licht den Halbleiterchip lediglich über die Oberseite des Strahlungskonversionselements verlassen. Ansonsten ist sowohl der Halbleiterchip als auch das Strahlungskonversionselement seitlich von der Vergussmasse umschlossen, während nach unten der Chipträger vorgesehen ist, so dass von dem Chipträger und der Vergussmasse Streulicht zurück im Halbleiterchip bzw. in dem Strahlungskonversionselement reflektiert werden, wo sie dann über Oberseite des Strahlungskonversionselements ausgekoppelt werden können. Damit wird im Wesentlichen eine Richtung der Strahlungsauskopplung vorgegeben, die senkrecht zu der Oberseite des Strahlungskonversionselements verläuft. Streustrahlung wird zurück in das Strahlungskonversionselement gebracht, und kann über die Oberseite ausgekoppelt werden, so dass insgesamt eine hohe Effizienz des optoelektronischen Bauelements erzielt wird.

Dadurch, dass der Halbleiterchip und das Strahlungskonversionselement seitlich von der Vergussmasse umhüllt sind, ist es zudem nicht notwendig, ein weiteres Gehäuse vorzusehen. Der Halbleiterchip und auch ein auf der Kontaktseite vorgesehenes Verbindungselement, wie beispielsweise ein Klebstoff oder Lötmaterial sind vor Umwelteinflüssen, insbesondere vor einem Kontakt mit der Atmosphäre oder mit Luftfeuchtigkeit bereits durch die Vergussmasse hinreichend geschützt.

Ein weiterer Vorteil ergibt sich durch den bündigen Abschluss zwischen der Oberseite des Strahlungskonversionselements und der Vergussmasse. Das optoelektronische Bauelement kann leicht an optische Elemente, wie beispielsweise einen Lichtwellenleiter, angekoppelt werden, da es nach oben eine völlig plane Oberfläche aufweist. Insgesamt wird ein optoelektronisches Bauelement bereitgestellt, das einen gut abgegrenzten Übergang zwischen einer Auskopplungsfläche in Form der Oberseite des Strahlungskonversionselements und einem reflektierenden, umrandenden Bereich in Form der Vergussmasse aufweist, so dass im Betrieb ein gut abgegrenzter Lichtkegel aus einer Auskopplungsfläche des optoelektronischen Bauelements abgestrahlt wird. Eine Einkoppelfläche eines Lichtwellenleiters kann räumlich sehr nah an die Leuchtfläche des optoelektronischen Bauelements gebracht werden.

In anderen Worten ausgedrückt, wird durch die reflektierende Vergussmasse ein seitlicher Reflektor bereitgestellt, der nicht nur den Halbleiterchip sondern auch das Strahlungskonversionselement umschließt. Durch die komplette seitliche Bedeckung wird Strahlung aus dem optoelektronischen Bauelement in einem begrenzten Raumwinkel in Richtung zur Normalen der Oberfläche des Strahlungskonversionselements ausgekoppelt. Verluste durch Streuung in seitlicher Richtung oder durch Absorption, beispielsweise am Chipträger, werden weitgehend vermieden.

In verschiedenen Ausführungsformen ist der Halbleiterchip über den Chipträger elektrisch kontaktiert. Dabei kann der Halbleiterchip, beispielsweise in Form eines Flipchips, sowohl p- als auch n-Kontakte auf seiner Kontaktseite aufweisen. Beide Kontakte können so direkt an den Chipträger angeschlossen werden. Damit wird vorzugsweise ein optoelektronisches Bauelement bereitgestellt, das keine Kontakte auf der Strahlungsauskopplungsseite aufweist, so dass keine Abschattung durch Kontaktelemente oder elektrische Verbindungen vorhanden sind.

In verschiedenen Ausführungsformen ist der Halbleiterchip über seine Strahlungsauskopplungsseite elektrisch kontaktiert, dies ist beispielsweise der Fall bei einer Leuchtdiode, die zumindest einen Kontakt, beispielsweise den n-Kontakt, auf der Strahlungsauskopplungsseite vorsieht.

In verschiedenen Ausführungsformen ist der elektrische Kontakt auf der Strahlungsauskopplungsseite über eine Leiterverbindung elektrisch mit dem Chipträger kontaktiert, so dass nach einer Verhäusung des optoelektronischen Bauelements die Anschlusskontakte sich lediglich am Chipträger befinden.

In verschiedenen Ausführungsformen ist die Leiterverbindung in der Vergussmasse eingebettet, so dass es nicht mehr notwendig ist, ein weiteres Gehäuse oder Schutzelement vorzusehen, um die Leiterverbindung beispielsweise vor Korrosion zu schützen.

In verschiedenen Ausführungsformen weist die Leiterverbindung einen Bonddraht auf. Damit kann auf ein Kontaktierungsverfahren zurückgegriffen werden, dass im Zusammenhang mit optoelektronischen Bauelementen bereits bekannt ist.

In verschiedenen Ausführungsformen ist eine vertikale Erstreckung des Bonddrahts über der Strahlungsauskopplungsseite kleiner als eine Höhe des Strahlungskonversionselements über der Strahlungsauskopplungsseite. Damit wird der Bonddraht in jedem Fall von der Vergussmasse bedeckt, da diese bündig an die Oberkante des Strahlungskonversionselements anschließt. Auch hier entfällt das Vorsehen eines weiteren Gehäuses zum Schützen des Bonddrahts. Zudem wird derart eine Bauteilhöhe des optoelektronischen Bauelements gering gehalten. Sie wird lediglich von den Höhen des Chipträgers, des Halbleiterchips und des Strahlungskonversionselements bestimmt. Es wird eine deutliche Miniaturisierung des optoelektronischen Bauelements erzielt, ohne dass auf spezielle Techniken, wie beispielsweise eine Durchkontaktierung, zurückgegriffen werden muss.

In verschiedenen Ausführungsformen liegt die vertikale Erstreckung des Bonddrahts über der Strahlungsauskopplungsseite in der Größenordnung von 20 bis 200 µm, beispielsweise bei 40 µm.

In verschiedenen Ausführungsformen weist die Vergussmasse ein Matrixmaterial, wie beispielsweise Silikon oder ein Epoxidharz auf. Dabei ist die Verwendung von Silikon besonders vorteilhaft, da sich Silikon leicht verarbeiten lässt und durch die von dem Halbleiterchip emittierte Strahlung nicht zerstört wird.

In verschiedenen Ausführungsformen weist die Vergussmasse dispergierte Streupartikel auf, die bewirken, dass die Vergussmasse eine reflektierende Vergussmasse ist. Beispielsweise weisen die Streupartikel Titandioxid auf. Es sind auch andere Streupartikel, beispielsweise Aluminiumoxid enthaltende Streupartikel denkbar.

In verschiedenen Ausführungsformen ist auf dem Strahlungskonversionselement ein optisches Element, beispielsweise eine Linse oder ein Lichtwellenleiter vorgesehen. Dieses optische Element lässt sich auf die plane Oberfläche des optoelektronischen Bauelements sehr leicht aufbringen und befestigen.

In verschiedenen Ausführungsformen des Verfahrens zum Herstellen eines optoelektronischen Bauelements wird die Vergussmasse durch ein Einspritzen eingebracht. Dabei kann die Vergussmasse beispielsweise durch ein Formpressen eingebracht werden. Dies kann insbesondere dadurch geschehen, dass die Vergussmasse durch eine in den Chipträger vorgesehene Öffnung eingebracht wird.

### KURZE BESCHREIBUNG DER ZEICHNUNGEN

Verschiedene Ausführungsbeispiele des optoelektronischen Bauelements und des Verfahrens zum Herstellen eines solchen optoelektronischen Bauelements werden im Folgenden anhand der Zeichnungen näher erläutert. In den Figuren gehen die erste(n) Ziffer(n) eines Bezugszeichens die Figur an, in dem das Bezugszeichen zuerst verwendet wird. Gleiche Bezugszeichen werden für gleichartige oder gleichwirkende Elemente bzw. Eigenschaften in allen Figuren verwendet.

Es zeigen
- **Fig. 1**: eine schematische Querschnittsdarstellung durch ein erstes Beispiel eines optoelektronischen Bauelements;
- **Fig. 2**: eine schematische Querschnittsdarstellung durch ein erstes Ausführungsbeispiel eines optoelektronischen Bauelements;
- **Fig. 3**: eine schematische Querschnittsdarstellung durch ein zweites Beispiel eines optoelektronischen Bauelements;
- **Fig.** 4: eine schematische Querschnittsdarstellung durch ein drittes Beispiel eines optoelektronischen Bauelements;
- **Fig. 5a und Fig.5b**: eine schematische Darstellung eines ersten Ausführungsbeispiels eines Verfahrens zum Herstellen eines optoelektronischen Bauelements und
- **Fig.6a bis Fig. 6d**: eine schematische Darstellung eines zweiten Ausführungsbeispiels eines Verfahrens zum Herstellen eines optoelektronischen Bauelements.

### AUSFÜHRUNGSBEISPIELE EINES OPTOELEKTRONISCHEN BAUELEMENTS

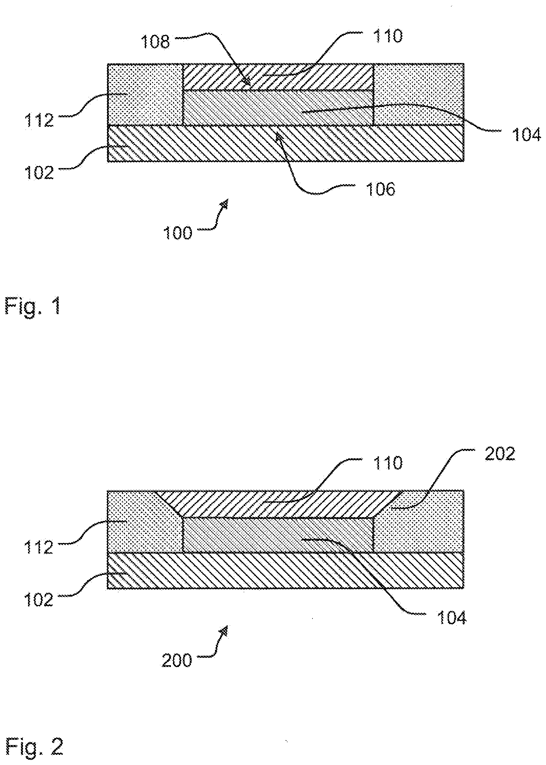

**Fig. 1** zeigt eine schematische Querschnittsdarstellung durch ein erstes Beispiel eines optoelektronischen Bauelements. Das optoelektronische Bauelement 100 weist einen Chipträger 102 auf. Der Chipträger kann dabei ein keramischer Träger oder ein Halbleiterträger sein, auf dem ein optoelektronischer Halbleiterchip 104 aufgebracht ist. Bei dem optoelektronischen Halbleiterchip 104 handelt es sich um eine Leuchtdiode oder um ein anderes optoelektronisches Element, das eine Strahlung emittiert oder absorbiert. Der optoelektronische Halbleiterchip 104 kann beispielsweise durch ein Dünnschichtverfahren hergestellt worden sein. Er weist eine Kontaktseite 106 auf, mit der er auf dem Chipträger 102 aufgebracht ist, und über die er zumindest einen elektronischen Kontakt aufweist. Dabei ist es denkbar, dass auch ein weiterer elektronischer Kontakt über die Kontaktseite an den Chipträger angeschlossen ist.

Auf der der Kontaktseite 106 gegenüberliegenden Seite weist der optoelektronische Halbleiterchip 104 eine Strahlungsauskopplungsseite 108 auf. Über die Strahlungsauskopplungsseite 108 wird eine in dem optoelektronischen Halbleiterchip 104 erzeugte Strahlung ausgekoppelt. Um eine möglichst effiziente Auskopplung der erzeugten Strahlung zu erreichen, kann der Chipträger 102 beispielsweise eine reflektierende Oberfläche im Bereich der Kontaktseite 106 aufweisen.

Auf der Strahlungsauskopplungsseite 108 ist ein Strahlungskonversionselement 110 aufgebracht. Das Strahlungskonversionselement 110 weist in aller Regel ein phosphoreszierendes Material auf, in dem Strahlung zumindest teilabsorbiert wird, die von dem optoelektronischen Halbleiterchip 104 emittiert wurde. Die Strahlung regt einen phosphoreszenten Übergang in dem Strahlungskonversionselement 110 an. Im Ergebnis wird von dem Strahlungskonversionselement 110 eine zweite Strahlung emittiert, deren Wellenlänge sich von der Strahlung aus dem optoelektronischen Halbleiterchip 104 unterscheidet. Derart kann das optoelektronische Bauelement 100 Strahlung über ein breites Frequenzspektrum emittieren.

Auf dem Chipträger 102 ist eine Vergussmasse 112 aufgebracht, die den optoelektronischen Halbleiterchip 104 und das Strahlungskonversionselement 110 seitlich vollständig umschließt. Die Vergussmasse 112 reicht dabei bis an eine Oberkante des Strahlungskonversionselements 110, d.h. dass sie bündig mit der Oberkante abschließt. Die Vergussmasse 112 weist typischerweise ein Matrixmaterial auf, beispielsweise Silikon oder auch ein Epoxidharz. In dem Matrixmaterial sind Streupartikel dispergiert. Bei den Streupartikeln handelt es sich typischerweise um Titandioxidpartikel oder um Aluminiumoxidpartikel. Da der optoelektronische Halbleiterchip 104 und das Strahlungskonversionselement 110 seitlich von der Vergussmasse 112 umschlossen sind, wird Streustrahlung, die von dem Halbleiterchip 104 oder dem Strahlungskonversionselement 110 seitlich emittiert werden, wieder zurückreflektiert und erreichen idealerweise wieder das Strahlungskonversionselement 110, von dem sie über die Oberseite ausgekoppelt werden können. Derart wird Strahlung nur über die Oberseite des Strahlungskonversionselements 110 ausgekoppelt und ist insofern scharf fokussiert, d.h. es wird ein gut abgegrenzter Übergang zwischen der Auskoppelfläche, die durch die Oberseite des Strahlungskonversionselements 110 dargestellt ist und dem umrandenden Bereich der Vergussmasse 112 erzielt, so dass ein gut abgegrenzter Lichtkegel aus einer Auskopplungsfläche des optoelektronischen Bauelements abgestrahlt werden kann.

Weil die Vergussmasse 112 bündig an die Oberseite des Strahlungskonversionselements 110 anschließt, weist das optoelektronische Bauelement 100 eine besonders plane Oberfläche auf. Zusätzlich ist der optoelektronische Halbleiterchip 104 vollständig von dem Strahlungskonversionselement 110, dem Chipträger 112 und der Vergussmasse 112 umschlossen, so dass kein weiteres Gehäuse zum Schutz des optoelektronischen Halbleiterchips 104 vorgesehen werden muss. Insgesamt kann so ein optoelektronisches Bauelement auf einfache Art und Weise hergestellt werden. Es eignet sich zur weiteren Verwendung, ohne dass eine besondere Vorkehrung getroffen werden muss, um eine Strahlungsauskopplung aus dem elektronischen Halbleiterchip 104 zu formen oder ein besonderes Gehäuse zum Schutz des optoelektronischen Halbleiterchips 104 vorzusehen.

**Fig. 2** zeigt eine schematische Darstellung eines Querschnitts durch ein erstes Ausführungsbeispiel eines optoelektronischen Bauelements gemäß der Erfindung. Das optoelektronische Bauelement 200 unterscheidet sich dabei von dem optoelektronischen Bauelement 100 des ersten Beispiels dadurch, dass das Strahlungskonversionselement 110 eine besondere Form aufweist. Dabei ist an dem Strahlungskonversionselement 110 eine Stoppkante 202 vorgesehen, die dazu dient beim Herstellen des optoelektronischen Bauelements 200 eine Grenze für eine seitliche Benetzung beim Vergießen mit der Vergussmasse 112 zu erzeugen, so dass die Vergussmasse 112 bündig an die Oberseite des Strahlungskonversionselements 110 anschließt.

In dem gezeigten ersten Ausführungsbeispiel weist das Strahlungskonversionselement 110 eine konusartige, d.h. pyramidenstumpfartige Form auf, so dass die Stoppkante 202 von der Oberfläche des optoelektronischen Halbleiterchips 104 weg verläuft und zusätzlich zu der Funktion als Benetzungsgrenze die Funktion eines Reflektors erfüllen kann. Der Verlauf der Stoppkante 202 kann dabei wie in der Zeichnung dargestellt, linear verlaufen. Es ist ebenso denkbar, dass andere Verläufe der Stoppkante 202 vorhanden sind, beispielsweise Verläufe, die konkav oder konvex verlaufen.

Das optoelektronische Bauelement 200 zeigt insbesondere die Eigenschaft, dass durch die Form der Stoppkante 202 ein Strahlungsverlauf der ausgekoppelten Strahlung fokussiert wird und in Richtung der Normalen der Oberfläche des Strahlungskonversionselements 110 verläuft.

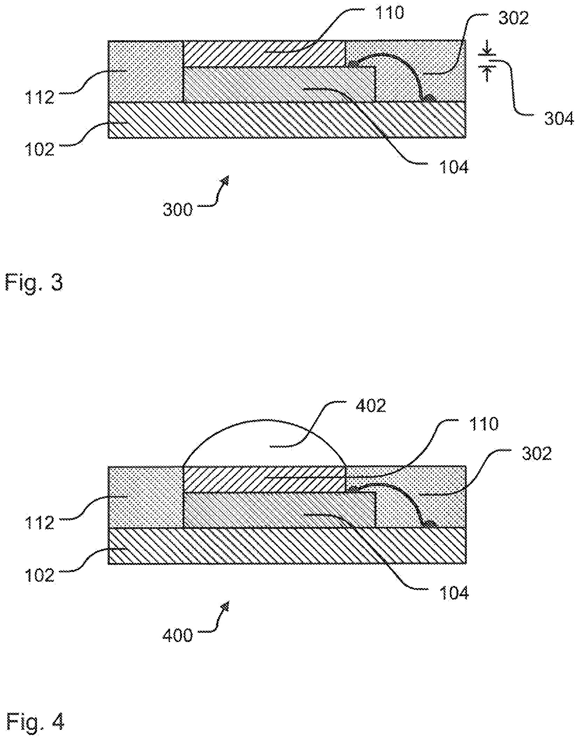

**Fig. 3** zeigt die schematische Darstellung eines Querschnitts durch ein zweites Beispiel eines optoelektronischen Bauelements. Das optoelektronische Bauelement 300 unterscheidet sich von dem optoelektronischen Bauelement 100 des ersten Beispiels darin, dass eine Leiterverbindung 302 vorgesehen ist, mit der ein Kontaktanschluss über die Strahlungsauskopplungsseite 108 zu dem Chipträger 102 hergestellt ist. Die Leiterverbindung 302 ist dabei insbesondere ein Bonddraht, der sich in seiner vertikalen Erstreckung 304 nicht höher als die Höhe des Strahlungskonversionselements über der Strahlungsauskopplungsseite 108 erhebt. Dadurch wird sichergestellt, dass die Leiterverbindung 302 vollständig von der Vergussmasse 112 umschlossen ist. Eine typische Größe für die vertikale Erstreckung 304 liegt in der Größenordnung von 20 bis 200 µm, beispielsweise bei 40 µm.

**Fig. 4** zeigt die schematische Darstellung eines Querschnitts durch ein drittes Beispiel eines optoelektronischen Bauelements, wobei das optoelektronische Bauelement 400 sich von dem optoelektronischen Bauelement 300 des zweiten Beispiels dadurch unterscheidet, dass über dem Strahlungskonversionselement, d.h. unmittelbar auf seiner Oberseite, ein optisches Element 402 in Form einer Linse aufgebracht ist. Damit kann eine weitere Strahlform der ausgekoppelten Strahlung erfolgen. Bei dem optischen Element 402 kann es sich, wie in der **Fig. 4** dargestellt, um eine Linse handeln. Ebenso ist es denkbar, dass sich es bei dem optischen Element um einen Lichtwellenleiter handelt, so dass die in dem optoelektronischen Halbleiterchip 104 erzeugte Strahlung vollständig in den Lichtwellenleiter eingebracht ist.

### AUSFÜHRUNGSBEISPIELE EINES VERFAHRENS ZUM HERSTELLEN EINES OPTOELEKTRONISCHEN BAUELEMENTS

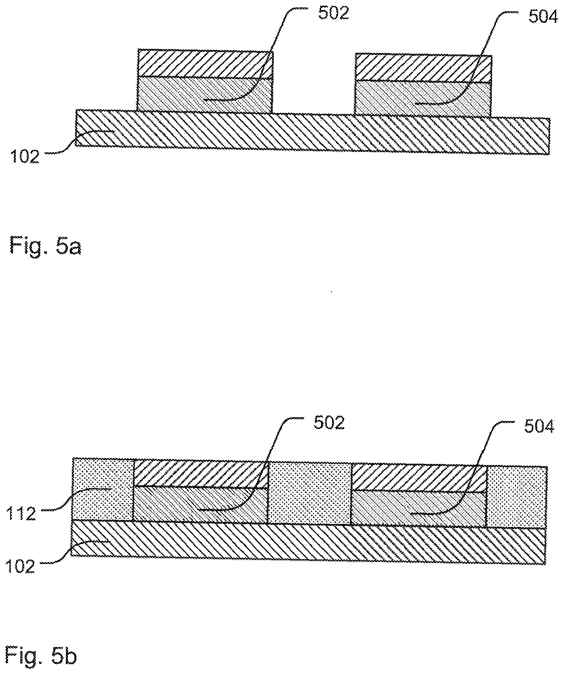

**Fig. 5a** und **Fig. 5b** zeigen eine schematische Darstellung eines ersten Ausführungsbeispiels eines Verfahrens zum Herstellen eines optoelektronischen Bauelements. Dabei wird, wie in **Fig. 5a** dargestellt, zunächst ein Chipträger 102 bereitgestellt, auf dem bereits ein erster optoelektronischer Halbleiterchip 502 und ein zweiter optoelektronischer Halbleiterchip 504 aufgebracht sind. Der erste optoelektronische Halbleiterchip 502 und der zweite optoelektronische Halbleiterchip 504 können beispielsweise durch ein *die attachment* oder durch ein *wafer level bonding* auf den Chipträger 102 befestigt sein. Auf dem ersten optoelektronischen Halbleiterchip 502 und dem zweiten optoelektronischen Halbleiterchip 504 sind jeweils ein Strahlungskonversionselement aufgebracht. Idealerweise weisen diese Strahlungskonversionselemente eine Stoppkante auf, wie sie in Bezug auf Fig. 2 beschrieben wurde. Zur Vereinfachung der Darstellung ist auf eine Darstellung der Stoppkante in der **Fig. 5a** und in der nachfolgenden **Fig. 5b** verzichtet worden.

Nachdem die Halbleiterchips auf dem Chipträger 102 bereitgestellt sind, wird der gesamte Chipträger 102 mit einer Vergussmasse 112 aufgefüllt, so dass sich eine Matrix aus Halbleiterchips 502 und 504 und Vergussmasse 112 ergibt, wie sie in der **Fig. 5b** dargestellt sind. Diese Matrix kann als Leuchtmodul verwendet werden, beispielsweise für Autoscheinwerfer oder Blitzlichter oder andere Anwendungen, es ist aber ebenso denkbar, dass nach Auffüllen mit der Vergussmasse 112 die optoelektronischen Halbleiterchips 502 und 504 vereinzelt werden, so dass einzelne optoelektronische Bauelemente entstehen, wie sie beispielsweise in den **Fig. 1** bis **Fig. 4** dargestellt sind.

Dieses Verfahren ist ein besonders einfaches Verfahren. Jedoch muss dabei sichergestellt sein, dass die Vergussmasse 112 bündig an die Oberseite der Strahlungskonversionselemente anschließt. Dies ist besonders vorteilhaft zu erreichen, in dem die Strahlungskonversionselemente eine Stoppkante, wie in **Fig. 2** dargestellt, aufweisen.

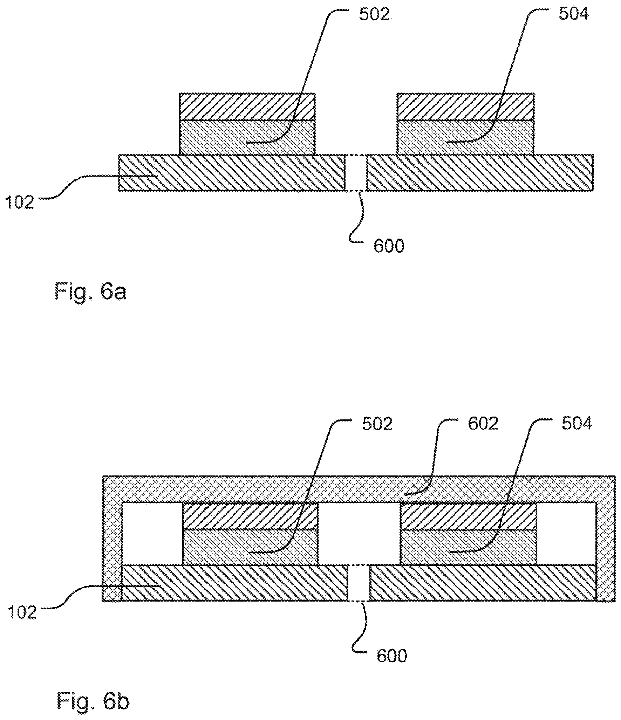

Die **Fig. 6a** bis **Fig. 6d** zeigen eine schematische Darstellung eines zweiten Ausführungsbeispiels eines Verfahrens zum Herstellen eines optoelektronischen Bauelements. Dieses Verfahren macht Gebrauch von einem sogenannten Formpressen (*compression molding*)*.* Dazu wird, wie in **Fig. 6a** dargestellt, ein Chipträger 102 bereitgestellt, auf dem ein erster optoelektronischer Halbleiterchip 502 und ein zweiter optoelektronischer Halbleiterchip 504, analog wie in dem Verfahren in der Beschreibung zu **Fig. 5a** beschrieben, aufgebracht sind. Der Chipträger 102 weist eine Öffnung 600 auf, die durch den Chipträger 102 reicht.

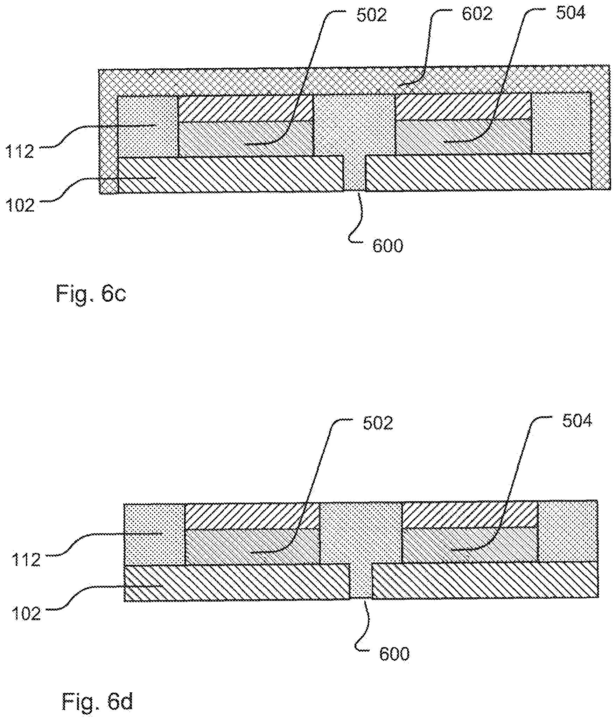

In einem zweiten Verfahrensschritt wird über die Halbleiterchips und den Chipträger 102 eine Pressform 602 aufgebracht. Der Chipträger 102 wird dabei von der Pressform 602 umschlossen, so dass ein Innenbereich nur noch durch die Öffnung 600 zu erreichen ist. Über die Öffnung 600 wird in einem weiteren Verfahrensschritt, wie in **Fig. 6c** dargestellt, die Vergussmasse 112 eingebracht. Dies geschieht vorzugsweise durch Einbringen unter Druck, wobei in der Vergussmasse 102 Streupartikel, wie Titandioxid, dispergiert sind.

Nach einem Aushärten der Vergussmasse kann die Pressform 602 entfernt werden, so dass anschließend ein Matrixmodul bereitgestellt ist, wie es in **Fig. 6d** dargestellt ist. Auch dieses Matrixmodul eignet sich zur Verwendung als Leuchte mit einer Vielzahl von optoelektronischen Halbleiterchips, beispielsweise für eine Anwendung als Autoscheinwerfer oder als Blitzlicht für mobile Anwendungen. Es ist aber auch ebenso denkbar, dass eine Vereinzelung durchgeführt wird, so dass anschließend einzelne optoelektronische Bauelemente, wie in den **Fig. 1** bis **Fig.4** dargestellt, erhalten werden.

Es ist dabei selbstverständlich, dass die Ausführungsbeispiele der Herstellverfahren derart modifiziert werden können, dass auch das zweite Ausführungsbeispiel, das dritte Ausführungsbeispiel oder das vierte Ausführungsbeispiel des optoelektronischen Bauelements erhalten werden kann.

### ABSCHLIESSENDE FESTSTELLUNG

Das optoelektronische Bauelement und das Verfahren zum Herstellen eines optoelektronischen Bauelements wurden zur Veranschaulichung des zugrunde liegenden Gedankens anhand einiger Beispiele und Ausführungsbeispiele beschrieben. Die Ausführungsbeispiele sind dabei nicht auf bestimmte Merkmalskombinationen beschränkt.

## Patentansprüche

1. Optoelektronisches Bauelement mit:
- einem optoelektronischen Halbleiterchip (104) mit einer Kontaktseite (106) und einer gegenüberliegenden Strahlungsauskopplungsseite (108);
- einem Chipträger (102) auf dem der Halbleiterchip (104) über seine Kontaktseite (106) aufgebracht ist;
- einem auf der Strahlungsauskopplungsseite (108) aufgebrachten Strahlungskonversionselement (110);
- einer auf dem Chipträger (102) aufgebrachten und den Halbleiterchip (104) und das Strahlungskonversionselement (110) seitlich umschließenden, reflektierenden Vergussmasse (112);
wobei die Vergussmasse (112) im Wesentlichen bündig an eine Oberkante des Strahlungskonversionselements (110) anschließt, so dass die Oberseite des Strahlungskonversionselements (110) frei von der Vergussmasse (112) ist, wobei das optoelektronische Bauelement durch den bündigen Abschluss der Vergussmasse (112) und des Strahlungskonversionselements (110) eine plane Oberfläche aufweist, welche eine plane Oberfläche der Vergussmasse (112) umfasst,
**dadurch gekennzeichnet, dass**
- sich das Strahlungskonversionselement (110) von der Strahlungsauskopplungsseite (108) zu einer Oberseite des Strahlungskonversionselements (110) hin aufweitet,

2. Optoelektronisches Bauelement gemäß Patentanspruch 1, wobei der Halbleiterchip (104) über den Chipträger (102) elektrisch kontaktiert ist.

3. Optoelektronisches Bauelement gemäß einem der vorangehenden Patentansprüche, wobei der Halbleiterchip (104) über seine Strahlungsauskopplungsseite (108) elektrisch kontaktiert ist.

4. Optoelektronisches Bauelement gemäß Patentanspruch 3, wobei die Strahlungsauskopplungsseite (108) über einer Leiterverbindung (302) elektrisch mit dem Chipträger (102) kontaktiert ist.

5. Optoelektronisches Bauelement gemäß Patentanspruch 4, wobei die Leiterverbindung (302) in der Vergussmasse (112) eingebettet ist.

6. Optoelektronisches Bauelement gemäß einem der Patentansprüche 4 oder 5, wobei die Leiterverbindung (302) einen Bonddraht aufweist.

7. Optoelektronisches Bauelement gemäß Patentanspruch 6, wobei eine vertikale Erstreckung (304) des Bonddrahts über der Strahlungsauskopplungsseite (108) kleiner ist, als eine Höhe des Strahlungskonversionselements (110) über der Strahlungsauskopplungsseite (108).

8. Optoelektronisches Bauelement gemäß einem der Patentansprüche 6 oder 7, wobei eine vertikale Erstreckung (304) des Bonddrahts über der Strahlungsauskopplungsseite (108) im Bereich von 20 bis 200 µm, beispielsweise bei 40 µm, liegt.

9. Optoelektronisches Bauelement gemäß einem der vorangehenden Patentansprüche, wobei die Vergussmasse (112) Silikon aufweist.

10. Optoelektronisches Bauelement gemäß einem der vorangehenden Patentansprüche, wobei die Vergussmasse (112) dispergierte Streupartikel aufweist.

11. Optoelektronisches Bauelement gemäß Patentanspruch 10, wobei die Streupartikel Titandioxid aufweisen.

12. Optoelektronisches Bauelement gemäß einem der vorangehenden Patentansprüche, mit einen auf dem Strahlungskonversionselement (110) aufgebrachten optischen Element (402), insbesondere einer Linse.

13. Verfahren zum Herstellen eines optoelektronischen Bauelements gemäß einem der vorstehenden Patentansprüche, wobei die Vergussmasse (112) durch Einspritzen eingebracht wird, wobei die Vergussmasse (112) durch ein Formpressen eingebracht wird.

14. Verfahren gemäß Patentanspruch 13, wobei die Vergussmasse durch eine in dem Chipträger (102) vorgesehene Öffnung (600) eingebracht wird.

## Claims

1. Optoelectronic component comprising:
- an optoelectronic semiconductor chip (104) having a contact side (106) and a radiation coupling-out side (108) situated opposite;
- a chip carrier (102), on which the semiconductor chip (104) is applied via its contact side (106);
- a radiation conversion element (110) applied on the radiation coupling-out side (108);
- a reflective potting compound (112), which is applied on the chip carrier (102) and laterally encloses the semiconductor chip (104) and the radiation conversion element (110);
wherein the potting compound (112) adjoins an upper edge of the radiation conversion element (110) in a substantially flush fashion, such that the top side of the radiation conversion element (110) is free of the potting compound (112), wherein, as a result of the flush termination of the potting compound (112) and the radiation conversion element (110), the optoelectronic component has a plane surface comprising a plane surface of the potting compound (112),
**characterized in that**
- the radiation conversion element (110) widens from the radiation coupling-out side (108) towards a top side of the radiation conversion element (110).

2. Optoelectronic component according to Patent Claim 1, wherein the semiconductor chip (104) is electrically contact-connected via the chip carrier (102).

3. Optoelectronic component according to either of the preceding patent claims, wherein the semiconductor chip (104) is electrically contact-connected via its radiation coupling-out side (108).

4. Optoelectronic component according to Patent Claim 3, wherein the radiation coupling-out side (108) is electrically contact-connected to the chip carrier (102) via a conductor connection (302).

5. Optoelectronic component according to Patent Claim 4, wherein the conductor connection (302) is embedded in the potting compound (112).

6. Optoelectronic component according to either of Patent Claims 4 and 5, wherein the conductor connection (302) has a bonding wire.

7. Optoelectronic component according to Patent Claim 6, wherein a vertical extent (304) of the bonding wire above the radiation coupling-out side (108) is less than a height of the radiation conversion element (110) above the radiation coupling-out side (108).

8. Optoelectronic component according to either of Patent Claims 6 and 7, wherein a vertical extent (304) of the bonding wire above the radiation coupling-out side (108) is in the range of 20 to 200 µm, for example 40 µm.

9. Optoelectronic component according to any of the preceding patent claims, wherein the potting compound (112) comprises silicone.

10. Optoelectronic component according to any of the preceding patent claims, wherein the potting compound (112) comprises dispersed scattering particles.

11. Optoelectronic component according to Patent Claim 10, wherein the scattering particles comprise titanium dioxide.

12. Optoelectronic component according to any of the preceding patent claims, comprising an optical element (402) applied on the radiation conversion element (110), in particular a lens.

13. Method for producing an optoelectronic component according to any of the preceding patent claims, wherein the potting compound (112) is introduced by injection, wherein the potting compound (112) is introduced by compression moulding.

14. Method according to Patent Claim 13, wherein the potting compound is introduced through an opening (600) provided in the chip carrier (102).

## Revendications

1. Composant optoélectronique comportant :
- une puce semi-conductrice optoélectronique (104) ayant une face de contact (106) et une face de sortie de rayonnement opposée (108) ;
- un support de puce (102) sur lequel la puce semi-conductrice (104) est appliquée par le biais de sa face de contact (106) ;
- un élément de conversion de rayonnement (110) appliqué sur la face de sortie de rayonnement (108) ;
- une pâte de surmoulage (112) réfléchissante appliquée sur le support de puce (102) et enfermant latéralement la puce semi-conductrice (104) et l'élément de conversion de rayonnement (110) ;
la pâte de surmoulage (112) affleurant sensiblement un bord supérieur de l'élément de conversion de rayonnement (110), de sorte que la face supérieure de l'élément de conversion de rayonnement (110) est exempte de la pâte de surmoulage (112), le composant optoélectronique présentant une surface plane du fait de l'affleurement de la pâte de surmoulage (112) et de l'élément de conversion de rayonnement (110), laquelle surface plane comprend une surface plane de la pâte de surmoulage (112),
**caractérisé en ce que**
- l'élément de conversion de rayonnement (110) s'élargit de la face de sortie de rayonnement (108) vers une face supérieure de l'élément de conversion de rayonnement (110).

2. Composant optoélectronique selon la revendication 1, dans lequel la puce semi-conductrice (104) est électriquement mise en contact au moyen du support de puce (102).

3. Composant optoélectronique selon l'une des revendications précédentes, dans lequel la puce semi-conductrice (104) est électriquement mise en contact au moyen de sa face de sortie de rayonnement (108).

4. Composant optoélectronique selon la revendication 3, dans lequel la face de sortie de rayonnement (108) est électriquement mise en contact avec le support de puce (102) au moyen d'une connexion de conducteur (302).

5. Composant optoélectronique selon la revendication 4, dans lequel la connexion de conducteur (302) est incorporée dans la pâte de surmoulage (112).

6. Composant optoélectronique selon l'une des revendications 4 ou 5, dans lequel la connexion de conducteur (302) présente un fil de liaison.

7. Composant optoélectronique selon la revendication 6, dans lequel une extension verticale (304) du fil de liaison au-dessus de la face de sortie de rayonnement (108) est inférieure à une hauteur de l'élément de conversion de rayonnement (110) au-dessus de la face de sortie de rayonnement (108).

8. Composant optoélectronique selon l'une des revendications 6 ou 7, dans lequel une extension verticale (304) du fil de liaison au-dessus de la face de sortie de rayonnement (108) est comprise dans une plage allant de 20 à 200 µm, par exemple est égale à 40 µm.

9. Composant optoélectronique selon l'une des revendications précédentes, dans lequel la pâte de surmoulage (112) présente du silicone.

10. Composant optoélectronique selon l'une des revendications précédentes, dans lequel la pâte de surmoulage (112) présente des particules de diffusion dispersées.

11. Composant optoélectronique selon la revendication 10, dans lequel les particules de diffusion présentent du dioxyde de titane.

12. Composant optoélectronique selon l'une des revendications précédentes, comportant un élément optique (402), en particulier une lentille, appliqué sur l'élément de conversion de rayonnement (110).

13. Procédé de fabrication d'un composant optoélectronique selon l'une des revendications précédentes, dans lequel la pâte de surmoulage (112) est introduite par injection, la pâte de surmoulage (112) étant introduite par moulage par compression.

14. Procédé selon la revendication 13, dans lequel la pâte de surmoulage est introduite par une ouverture (600) prévue dans le support de puce (102).
